Europäisches Patentamt

European Patent Office

Office européen des brevets

(19)

(11) Publication number: 0 199 109
A2

## (12) EUROPEAN PATENT APPLICATION

(21) Application number: 86103892.5

(22) Date of filing: 21.03.86

(51) Int. Cl.⁴: $H01L\ 27/06$

(30) Priority: 25.03.85 US 715330

(43) Date of publication of application:
29.10.86 Bulletin 86/44

(84) Designated Contracting States:
DE FR GB IT

(71) Applicant: HONEYWELL INC.
Honeywell Plaza
Minneapolis Minnesota 55408(US)

(72) Inventor: Peczalski, Andrzej
1051 - 29th Avenue S.E., Apartment C.
Minneapolis Minnesota 55414(US)

(74) Representative: Rentzsch, Heinz et al
Honeywell Europe S.A. Holding KG Patent-
und Lizenzabteilung Kaiserleistrasse 55
D-6050 Offenbach am Main(DE)

(54) Bootstrap field effect transistor.

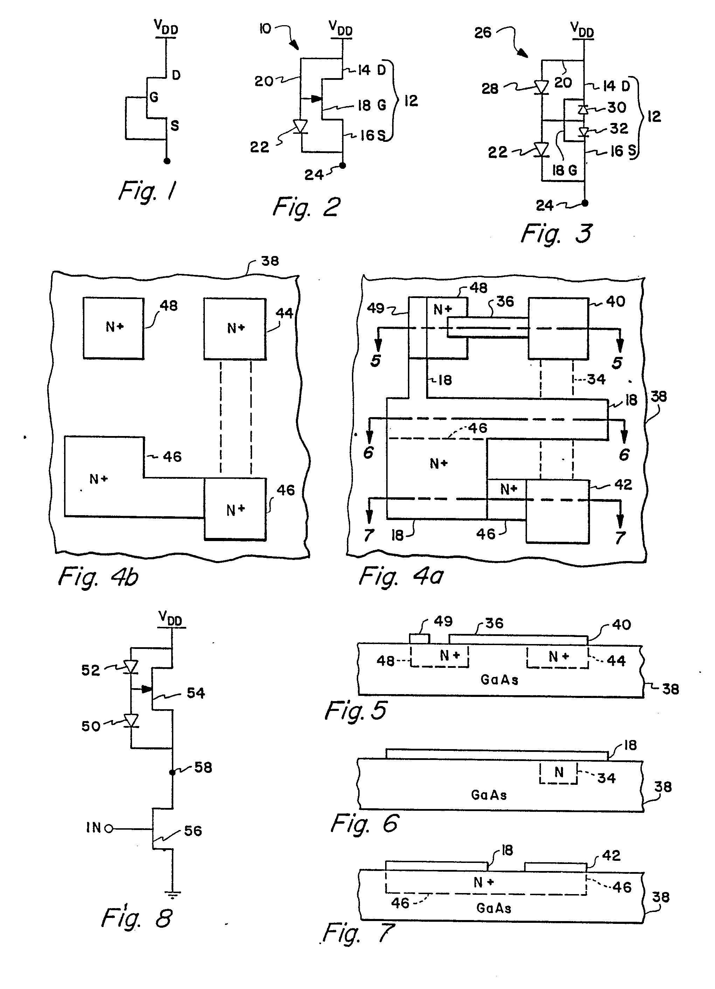

(57) The gate to source voltage of a MESFET (10) is increased by connecting a diode (22) therebetween. The diode is placed in a conductive path (20, 22) connecting the drain and source and allows substantial current to flow only towards the source. The conductive path may include other diodes (28, 57, 66, 68) connected in series between the gate (18) and drain region (14, 44). The bootstrap gate to source voltage increases the drain to source current (Fig. 2).

Fig. 2

EP 0 199 109 A2

# BOOTSTRAP FIELD EFFECT TRANSISTOR

This invention relates to MESFETs (Metal-Semiconductor Field Effect Transistors) in pull-up and pull-down configuration where a diode is used to bootstrap the gate to source voltage.

MISFET (Metal-Insulated-Semiconductor Field Effect Transistor) bootstrap circuits using capacitors to increase gate to source voltage are known. For example, in US-A 3 898 479 a bootstrap capacitor is used to increase the gate voltage of an active load MISFET to a value in excess of the drain voltage. This allows rapid switching of the transistor. Similar circuits are found in US-A 3,774,055 and 4,443,720. The insulating layer between the gate and substrate allows large bootstrap voltages to be used with MOSFETs because no current can flow into the channel from the gate. Current injected through the gate in a FET would have a substantial detrimental impact on circuits incorporating the MOSFET since it would cause a voltage drop on the source resistance and therefore decrease the device current. This would alter the expected MOSFET I-V characteristics.

In a MESFET, the absence of the insulating layer requires that great care is taken in designing a bootstrap circuit with a capacitor. Further, capacitors take up inordinately large chip area and are relatively difficult to process. Active load MESFETs have not been provided with bootstrap capacitors. Instead, the gate and source have simply been shorted (See Figure 1).

An active load bootstrap MESFET which does not employ a capacitor and is otherwise area conservative, would be a highly desirable component which could enhance logic circuit performance. This object is achieved by the invention as characterized in claim 1.

The invention is a bootstrap MESFET including a conductive path between drain and gate, and a diode connected between the gate and source wherein the diode is slightly forward biased allowing current to flow only toward the source. The diode increases the gate to source voltage thus increasing the drain current and enhancing the drive capability of circuits employing the bootstrap MESFETs as an active pull-up or pull-down device. Further details and improvements of the invention are described in the subclaims.

Additional diodes may be placed in series along the conductive path, with the diodes slightly forward biased to allow current to only flow along the conductive path toward the source.

The diodes are preferably Schottky diodes. The MESFET is preferably a depletion mode device with a gallium arsenide substrate.

Methods of enhancing MESFET logic families corresponding to the operation of the above bootstrap MESFET are also disclosed.

## BRIEF DESCRIPTION OF THE DRAWINGS

Figure 1 is an electrical schematic of a prior art active load MESFET.

Figure 2 is an electrical schematic of a first embodiment of the present invention.

Figure 3 is an electrical schematic of a second embodiment of the present invention.

Figures 4a and 4b are plan views of an integrated circuit incorporating the circuit of figure 2, with 4a showing a Schottky and ohmic metal layers and 4b showing these layers removed.

Figure 5 displays the cross section taken along line 5-5 of figure 4a.

Figure 6 displays the cross section taken along line 6-6 of figure 4a.

Figure 7 displays the cross section taken along line 7-7 of figure 4a.

Figure 8 is a DCFL NOR gate with bootstrap.

Figures 9a and 9b show computer simulation results comprising the operation of a DCFL NOR gate with and without bootstrap.

Figure 10 is an SDFL NOR gate with bootstrap.

Figures 11a and 11b show computer simulation results comparing the operation of a SDFL NOR gate with and without bootstrap.

Figure 12 is an SDFL inverter with bootstrap.

Figures 13a and 13b show computer simulation results comparing of an SDFL inverter with and without bootstrap.

## DESCRIPTION OF THE PREFERRED EMBODIMENT

Circuit 10 of Figure 2 depicts the first embodiment of the present invention. A MESFET 12 includes drain region 14, source region 16, gate 18, conductive path 20 extending between drain 14 and gate 18 and bootstrap diode 22 connected between gate 18 and source 16 with the forward current direction of diode 22 being towards source 16. Circuit 10 also typically includes an output node 24.

$$I_{DS} = \beta(V_{GS} - V_T)^2$$

$$\text{(1)}$$

$$\text{where} \quad V_T = \text{pinch off voltage}$$

$$\text{and} \quad \beta = \frac{I_{DS}\Big|_{V_{GS} = 0}}{\sqrt{V_T}}$$

For N-channel depletion mode operation - (i.e.,normally on MESFET) the gate threshold voltage ($V_T$) will be negative. Further, since the current flows from $V_{DD}$ to the source, the voltage drop across the bootstrap diode 22 is positive (i.e., $V_{GS} > 0$). Equation 1 indicates that for $V_T < 0$ and $V_{GS} > 0$, $I_{DS}$ will increase as compared to the standard active load (i.e. see Figure 1). That is for circuit 10, $I_{DS}$ will be given by:

$$\beta(V_{GS} + V_T)^2 \text{ (2)}$$

as compared to:

$$\beta(V_T)^2 \text{ (3)}$$

for the standard active load MESFET.

This increased current will enhance the drive capabilities of MESFET logic circuits employing circuit 10.

The present invention may further include one or more additional diodes connected in series along conductive path 20. The additional diodes should allow substantial current to only flow from the drain region 14 to the source region 16. All diodes along conductive path 20 should be slightly forward biased, i.e., forward biased but biased to

Placing diode 22 as shown in Figure 2 eases circuit design requirements. If diode 22 were reversed, voltage $V_{DD}$ would have to be strictly maintained to guard against injecting unwanted current into channel region 34 (see Figure 4b).

The relationship of the saturation drain current ($I_{DS}$) and gate/source voltage ($V_{GS}$) of a MESFET is approximated by:

less than the barrier voltage of the diodes. See the discussion below regarding equation 4 for further information regarding biasing the diodes. Circuit 26 of figure 3 displays one additional diode 28.

Figure 3 also superimposes two diodes 30 and 32 in series between drain 14 and source 16. Diodes 30 and 32 represent equivalent circuit models of the gate/drain and gate/source junctions, respectively, of MESFET 12. Note that diode 30 is always reversed biased and no current will be injected in the channel region 34 (see Figure 6) through diode 30. Diode 32, however, can become forward biased under certain conditions. If diode 32 is forward biased current could be injected into channel 34 through gate 18, which, as discussed above, will substantially alter the I-V characteristics of MESFET 12. In order to preserve the general shape of the I-V characteristics of MESFET 12, diode 32 should not conduct substantial current and is preferably reverse biased.

A convenient method of insuring that diode 32 will not conduct substantial current is to choose MESFET 12 so that the turn-on voltage ($V_B$) of diode 32 is greater than the barrier voltage of diode 22.

Further, in order for MESFET 12 to function as an an active load without currents from the voltage source $V_{DD}$ simply bypassing MESFET 12 by way of conductive path 20, diodes 22 and 28 (as well as the voltage levels of circuits employing circuit 10) must be properly selected.

In particular, the maximum voltage between drain 14 and source 16 must be greater than or equal to the sum of the turn-on voltages for the diodes along conductive path 20 and the bootstrap diodes. That is:

$$V_{DD}\text{-}V_{OL} \geq \sum_i V_{Bi} \quad (4)$$

where $V_{Bi}$ = turn-on voltage of $i_{th}$ diode,

i = number of diodes from drain to source, and

$V_{OL}$ = lowest output voltage appearing at node 24 during circuit operation.

In figure 3, i = 2 however, i can be virtually any number. Typically i will be four or less.

As $V_{DD}$ is increased, the drive capability - (including the speed) of circuits including the present invention will generally increase. Thus as $V_{DD}$ increases, more diodes such as diodes 22 and 28 will usually be employed.

Generally all diodes such as 22 and 28 will be the same, however, equation 4 could be satisfied with such diodes being different. In selecting diodes for the bypass conductive path one is still constrained by the preferred relationship of the barrier voltages of diodes 22 and 32. Thus the area of diode 22 should be several times larger than area of diode 32. Thus the area of diode 22 should be several times larger than area of diode 32.

Figures 4a, 4b, 5, 6 and 7 show plan views of a convenient integrated circuit incorporating the circuit of Figure 3 and three different cross sectional views.

Corresponding structures between Figures 4 and 4b, and Figure 3 are like numbered. Schottky metal 3b can be, for example, $(TiW)Si_x$. The substrate 38 is preferably gallium arsenide. Drain contact 40 and source contact 42 are an ohmic metal such as an Au/Ge based metal system. Contacts 40 and 42 overlie heavily doped drain and source regions 44 and 46, respectively. Channel region 34 is implanted with dopants of the same conductivity type as drain and source regions 44 and 46 but is not as heavily doped. Source region 46 is extended to allow a portion of Schottky metal 18 and and the source region 46 to form part of diode 22. The ohmic contact of diode 22 is common with source 46. A separate heavily doped diffusion 48 and ohmic metal patch 49 are employed as part of diode 28. The Schottky barrier of diode 28 is created by the Schottky metal finger 36 which is connected to drain 40. Because MESFET 12 is preferably formed by placing metal on a semiconductor substrate such as gallium arsenide, diodes such as diodes 22 and 28 are preferably Schottky diodes.

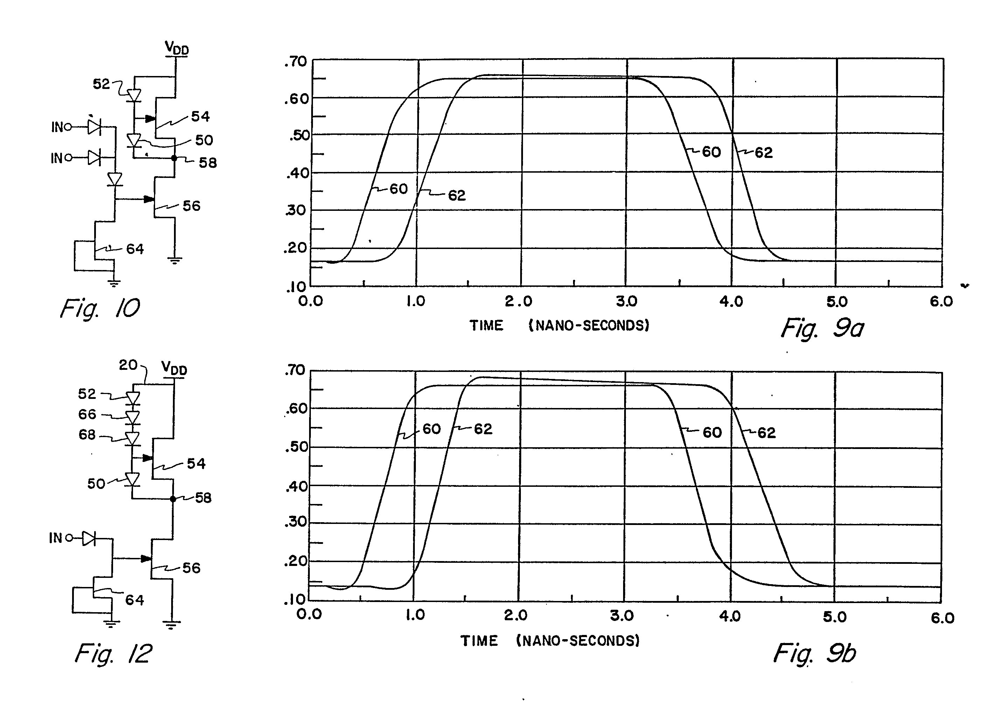

Figure 8 shows a DCFL (i.e. direct coupled FET logic) NOR gate with bootstrap diode 50 and additional diode 52. MESFET 54 serves as an active load with MESFET 56 serving as a switch. The ouput is taken at node 58.

Figure 9a shows the performance of the circuit of Figure 8 with the standard active load of Figure 1 substituted for the bootstrap active load shown in Figure 8. Figure 9a depicts an input voltage 60 applied to the gate of MESFET 56 and the output voltage 62 at node 58 of the next gate in the chain. At the .45 midrange of the vertical axis the response time is just over 1 nanosecond. In Figure 9b the performance of the circuit Figure 8 with bootstrap is shown and the response time at the midrange of .45 of input voltage 60 compared to output voltage 62 is substantially less than 1 nanosecond. The time shift between signal 60 and 62 is equal to two gate delays. In fact a gate delay improvement of approximately 14% was observed.

The following is a list of parameters used in generating the data shown in Figures 9a and 9b:

| | Load Transistor | Switching Transistor |
|---|---|---|
| Threshold Voltage [V] | -0.62 | 0.18 |
| Gain Parameter $[A/V^2]$ | $1.56 \times 10^{-4}$ | $7 \times 10^{-4}$ |
| Source Resistance [Ohms] | 667 | 267 |
| Output Conductance $[I/V]$ | 0.1 | 0.25 |
| Parasitic Capacitance [fF] | 5.4 | 5.9 |
| Gate Length $[\mu m]$ | 2 | 2 |
| Gate Width $[\mu m]$ | 3/1.5 | 9 |
| Load Capacitance $[fF]$ | 25 | |

| | Schottky Current pA | Resistance Ohms | Ideality Factor | Capacitance |
|---|---|---|---|---|
| Transistor Diode (30, 32) | 0.35 | 0 | 1.35 | 0 |
| Bootstrap Diode 5x9 $[\mu m]$ | 49.5 | 82 | 1.52 | 90fF |

Figure 10 shows a Schottky diode FET logic (SDFL) NOR gate with bootstrap. Similar components between Figures 8 and 10 are like numbered. MESFET 64 serves as a current source.

Figures 11a and 11b show a comparison (similar to that made in Figures 9a and 9b) between an SDFL NOR gate with and without, respectively, bootstrap. Input and ouput voltages are again numbered 60 and 62, respectively. The gate speed is again seen to increase and the increase was approximately 15% percent. The following is a list of parameters used in generating the data shown in Figures 11a and 11b:

| | Load Transistor | Switching Transistor | Pull Down Transistor |
|---|---|---|---|
| Threshold Voltage [V] | -0.38 | -0.38 | -0.38 |
| Gain Parameter $/\bar{A}/V^2/$ | $8.56 \times 10^{-4}$ or $4.28 \times 10^{-4}$ | $7.7 \times 10^{-4}$ | $5.9 \times 10^{-5}$ |
| Source Resistance $/Ohms/$ | $50/100$ | 56 | 300 |
| Output Conductance $/\bar{1}/\bar{V}/$ | 0.08 | 0.05 | 0.15 |
| Parasitic Capacitance $/fF/$ | $13.4/6.7$ | 12 | 42.9 |
| Gate Length $/\mu m/$ | 1 | 1 | 16 |
| Gate Width $/\mu m/$ | 10/5 | 9 | 2 |
| Load Capacitance $/fF/$ | 350 | -- | -- |

| | Schottky Current pA | Resistance Ohms | Ideality Factor | Capacitance fF |
|---|---|---|---|---|
| Transistor Diode | 12.8 | 0 | 1.52 | 0 |
| Bootstrap Diode 5x9 $/\mu m/$ | 49.5 | 82 | 1.52 | 90 |

Figure 12 shows a SDFL inverter with bootstrap. The operation of the circuit of Figure 12 was compared both with and without bootstrap. Similar components between Figures 10 and 12 are like numbered. Additional diodes 66 and 68 are placed along conductive path 20.

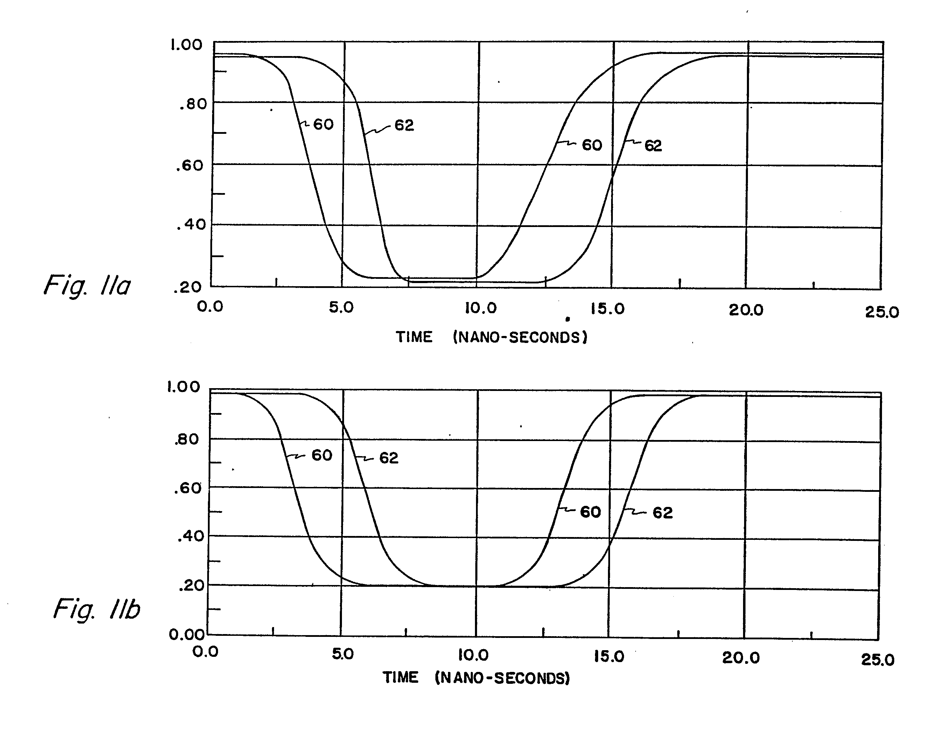

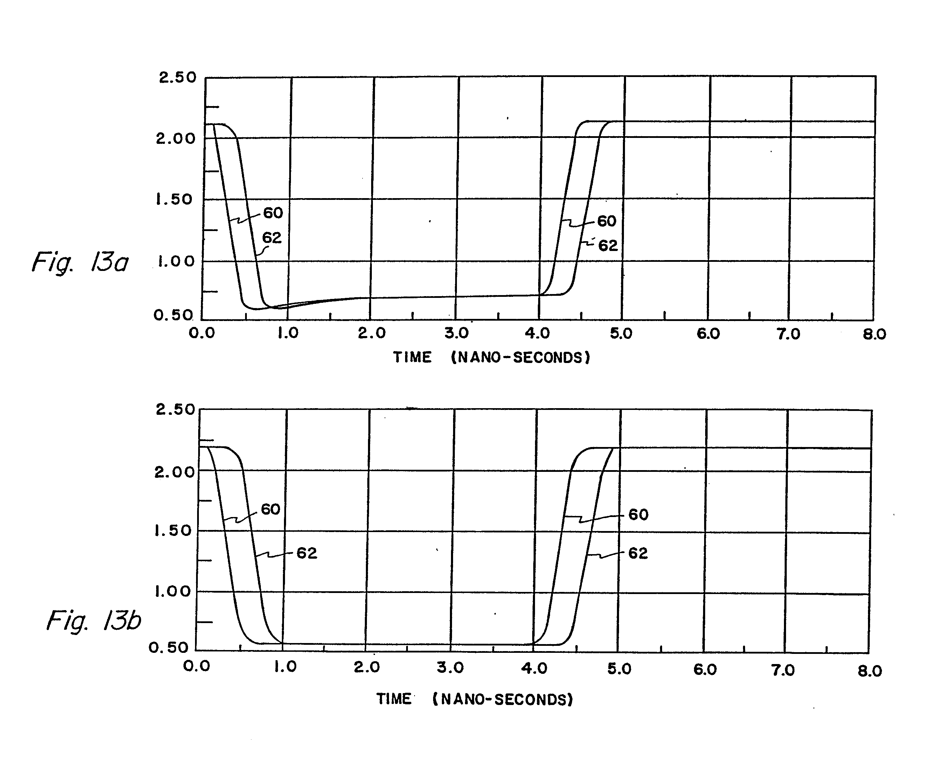

The computer simulation results of this comparison of the SDFL inverter both with and without bootstrap are shown respectively in Figures 13a and 13b. Input and output voltages are numbered 60 and 62, respectively. The speed improvement with bootstrap in this case was approximately 18%. The following is a list of parameters used in generating the data shown in Figures 13a and 13b:

|  | Load Transistor | Switching Transistor | Pull Down Transistor |
|---|---|---|---|
| Threshold Voltage [V] | -0.9 | -0.9 | -0.9 |
| Gain Parameter $\boxed{A/V^2}$ | $1/0.74 \times 10^{-3}$ | $0.81 \times 10^{-3}$ | $0.2 \times 10^{-3}$ |
| Source Resistance $\boxed{Ohms}$ | $40/55$ | 50 | 200 |
| Output Conductance | 0.08 | 0.08 | 0.08 |
| Parasitic Capacitance $\boxed{fF}$ | $18.3/13.4$ | 14.6 | 3.7 |
| Gate Length $\boxed{\mu m}$ | 1 | 1 | 1 |
| Gate Width $\boxed{\mu m}$ | 15/11 | 12 | 3 |
| Load Capacitance $\boxed{fF}$ | 100 | -- | -- |

|  | Schottky Current | Resistance Ohms | Ideality Factor | Capacitance fF |
|---|---|---|---|---|
| Transistor Diode | 71 | 0 | 1.52 | 0 |
| Bootstrap Diode $\underset{\boxed{\mu m}}{8 \times 8}$ | 312 | 16.9 | 1.52 | 44 |

The power dissipated by the circuits simulated with and without bootstrap is kept at the same level respectively.

Enhanced performance similar to that described immediately above is expected with all MESFET logic familites and with all MESFET logic gates.

**Claims**

1. A bootstrap field effect transistor, comprising: a solid substrate (38) having a principal surface and being doped with a first conductivity type (e.g. P) a drain region (14, 44) extending into said substrate - (38) and being doped with a second conductivity type (N);

source region (16, 46) extending into said substrate and being doped with said second conductivity type; means for providing a channel (34) in said substrate extending between said source and drain regions;

a conductive gate (18) overlying at least a portion of said channel and being in contact with said principal surface; **characterized by**

a conductive path (20, 36, 46, 48, 49) connecting said drain region (14, 44) to said source region (16, 46) and to said gate (18); and

a first diode (22; part of 18 and 46) in said conductive path connected between said gate and said source, said first diode being adapted to allow substantial current to flow only toward said source region.

2. A transistor of claim 1, **characterized in that** said channel (34) is doped with said second conductivity type (e.g. N).

3. A transistor of claim 1 or 2, **characterized by:**

at least one second diode (28; 48, and 49) connected between said drain (14, 44) and gate (18) along said conductive path, wherein said first (22) and second (28, 48, 49) diodes are each adapted to allow substantial current to only flow in the same direction between said source region and said drain region.

4. A transistor of claim 3, **characterized by** a plurality of diodes (52, 66, 68) connected in series between said drain region (14, 44) and gate (18) along said conductive path (20), said plurality of diodes adapted to allow substantial current to flow only in the same direction that substantial current can flow through said first diode (50).

5. A transistor of one of the preceding claims, **characterized in that** said gate (18) and substrate (38) form an interface and said interface has an interface barrier potential; and

said first diode (22) has a diode barrier potential wherein said diode barrier potential is greater than said interface barrier potential.

6. A transistor of one of the preceding claims, **characterized by:**

means for applying a potential difference (V$_{DD}$) between said source region (16, 46) and said drain region (14, 44), wherein said potential difference never exceeds the total of the barrier potentials of said first diode (22) or of said diodes (22, 28; 50, 52, 66, 68), respectively.

7. A transistor of one of the preceding claims, **characterized in that**

the solid substrate is doped with the first conductivity type except for selected regions;

the drain region (14, 44) is one of said selected regions and extends into said substrate (38) from said principal surface;

the source region (16, 46) is another of said selected regions;

the channel (34) extends into said substrate (38) from said principal surface;

a first ohmic contact (40) overlies and forms an ohmic contact with said drain region (14, 44);

the first diode region (22, part of 46) is another of said selected regions, extends into said substrate - (38) from said principal surface, is doped with said second conductivity type, is connected to said conductive gate (18), and forms a rectifying contact with said conductive gate (18);

a second ohmic contact (42) overlies and forms an ohmic contact with said source region (16, 46);

a first conductive path (20, 36, 48, 49) extends from said first ohmic contact (40) to said conductive gate (18); and

a second conductive path (part of 46) extends from said first diode region (22) to said second ohmic contact (42).

8. A transistor of claim 7, **characterized in that** said channel (34) is another of said selected regions and is doped with said second conductivity type (N).

9. The transistor of claim 7 or 8, **characterized in that:**

the second diode region (28, 48) is another one of said selected regions, extends into said substrate - (38) from said principal surface, is doped with said second conductivity type (N), forms a part of said first conductive path (20, 36, 48, 49) and forms a rectifying contact with a portion (20, 49) of said first conducting path (26, 36, 48, 49).

10. A transistor of one of the preceding claims, **characterized in that** the solid substrate consists of gallium arsenide.

Fig. 1

Fig. 2

Fig. 3

Fig. 4b

Fig. 4a

Fig. 8

Fig. 5

Fig. 6

Fig. 7

Fig. 10

Fig. 12

TIME   (NANO-SECONDS)

Fig. 9a

TIME   (NANO-SECONDS)

Fig. 9b

0 199 109

Fig. IIa

TIME (NANO-SECONDS)

Fig. IIb

TIME (NANO-SECONDS)

0 199 109

Fig. 13a

TIME (NANO-SECONDS)

Fig. 13b

TIME (NANO-SECONDS)